# EUROPEAN PATENT APPLICATION

(11) **EP 4 822 741 A1**
(43) Date of publication of application: **14.10.2026**
(21) Application number: 24899573.0
(22) Date of filing: 12.11.2024
(51) Int. Cl.: H01L 23/31, H01L 23/48, H01L 23/522, H01L 23/528, H01L 23/64, H01L 21/56

(54) **CHIP PACKAGING STRUCTURE, FLIP CHIP PACKAGING METHOD, AND ELECTRONIC DEVICE**

(30) Priority: 05.12.2023 CN 202311665822
(71) Applicant: Huawei Technologies Co., Ltd., Shenzhen, Guangdong 518129 (CN)
(72) Inventor: HAN, Jixuan, Shenzhen, Guangdong 518129 (CN); JING, Weiliang, Shenzhen, Guangdong 518129 (CN); ZHANG, Shiwei, Shenzhen, Guangdong 518129 (CN); LIU, Shuguang, Shenzhen, Guangdong 518129 (CN); LIU, Shuai, Shenzhen, Guangdong 518129 (CN)
(74) Representative: Huawei European IPR
(86) International application number: PCT/CN2024/131595
(87) International publication number: WO 2025/118931

(57) **Abstract**

This application provides a chip packaging structure, a flip chip packaging method, and an electronic device, and relates to the semiconductor field, which can filter out high-frequency noise without occupying resources of a die and an electronic component. The chip packaging structure includes a die, an electronic component, a plurality of conductive bumps, and a first capacitor. The die includes a first trace, and the electronic component includes a second trace and a third trace. The plurality of conductive bumps are disposed between the die and the electronic component, and the plurality of conductive bumps include a first conductive bump and a second conductive bump. The first capacitor is disposed between the die and the first conductive bump, the first trace is electrically connected to the second trace through the first capacitor and the first conductive bump, and the first trace is further electrically connected to the third trace through the second conductive bump. The first trace and the third trace are ground traces, and the second trace is a power supply trace; or the first trace and the third trace are power supply traces, and the second trace is a ground trace.

## Description

This application claims priority to Chinese Patent Application No. 202311665822.7, filed with the China National Intellectual Property Administration on December 5, 2023 and entitled "CHIP PACKAGING STRUCTURE, FLIP CHIP PACKAGING METHOD, AND ELECTRONIC DEVICE", which is incorporated herein by reference in its entirety.

### TECHNICAL FIELD

This application relates to the semiconductor field, and in particular, to a chip packaging structure, a flip chip packaging method, and an electronic device.

### BACKGROUND

As the rate, power consumption, and complexity of a chip increase, power integrity (power integrity, PI) of the chip gradually becomes a key bottleneck for overall functionality and performance of the chip, resulting in an increased demand for decoupling capacitors (decaps) on the chip. Based on placement positions of decoupling capacitors, the decoupling capacitors are classified into the following types: on-die decoupling capacitors (on-die decap), on-package decoupling capacitors (package decap), and on-board decoupling capacitors (board decap).

However, an on-die decoupling capacitor occupies resources on a die, resulting in high costs. The on-package decoupling capacitor affects trace routing on a package substrate and increases assembly costs of the package substrate, and decoupling capacitor density is low. In addition, the decoupling capacitor is far away from a load of the die, which is not conducive to filtering out high-frequency noise. A filtering range of an on-board decoupling capacitor is limited, mainly filtering out low-frequency noise.

Therefore, how to use the decoupling capacitor to filter out high-frequency noise without occupying active region resources of the die and the package substrate is an urgent problem to be resolved currently.

### SUMMARY

To resolve the foregoing technical problem, this application provides a chip packaging structure, a flip chip packaging method, and an electronic device, and a first capacitor is disposed between a die and a first conductive bump, which can filter out high-frequency noise without occupying resources of the die and an electronic component.

According to a first aspect, this application provides a chip packaging structure, where the chip packaging structure includes a die, an electronic component, a plurality of conductive bumps, and a first capacitor. The die includes a first trace, and the electronic component includes a second trace and a third trace. The plurality of conductive bumps are disposed between the die and the electronic component, and the plurality of conductive bumps include a first conductive bump and a second conductive bump. The first capacitor is disposed between the die and the first conductive bump, the first trace is electrically connected to the second trace through the first capacitor and the first conductive bump, and the first trace is further electrically connected to the third trace through the second conductive bump. The first trace and the third trace are ground traces, and the second trace is a power supply trace; or the first trace and the third trace are power supply traces, and the second trace is a ground trace.

The first capacitor in this application is used as a decoupling capacitor, and the first capacitor is disposed between the die and the first conductive bump by occupying a part of an original position of the first conductive bump. In addition, the first capacitor is further electrically connected to the second trace through the first conductive bump, so that the first capacitor is electrically connected between the power supply trace and the ground trace. Compared with an on-die decoupling capacitor, the first capacitor in this application does not need to occupy resources on the die, thereby reducing costs. Compared with an on-package decoupling capacitor, the first capacitor in this application does not affect a trace of the electronic component, thereby reducing costs, and allowing for high-density arrangement of first capacitors. In addition, a distance between the first capacitor in this application and an active region of the die is shorter than a distance between the on-package decoupling capacitor and the active region of the die. Therefore, the first capacitor in this application is more conducive to filtering out high-frequency noise. The distance between the first capacitor in this application and the active region of the die is shorter than a distance between an on-board decoupling capacitor and the active region of the die. Therefore, the first capacitor in this application is more conducive to filtering out high-frequency noise.

In some possible implementations, the die further includes a fourth trace, the plurality of conductive bumps further include a third conductive bump, and the fourth trace is electrically connected to the second trace through the third conductive bump. Both the second trace and the fourth trace are ground traces; or both the second trace and the fourth trace are power supply traces. In this way, for example, one transistor is electrically connected between a power supply trace and a ground trace, the first capacitor is electrically connected between the power supply trace and the ground trace, a drain of the transistor is electrically connected to the ground trace, and a source of the transistor is electrically connected to the power supply trace.

In some possible implementations, there are a plurality of first capacitors and a plurality of first conductive bumps, and the plurality of first capacitors are connected in parallel between the first trace and the second trace. In this way, different capacitance requirements can be further met by designing respective capacitance values of two first capacitors based on a parallel connection relationship between the two first capacitors.

In some possible implementations, the chip packaging structure further includes a second capacitor. The second capacitor is disposed between the first conductive bump and the electronic component, and the first trace is electrically connected to the second trace through the first capacitor, the first conductive bump, and the second capacitor.

Compared with an on-die decoupling capacitor, the second capacitor in this application does not need to occupy resources on the die, thereby reducing costs. Compared with an on-package decoupling capacitor, the second capacitor in this application does not affect a trace of the electronic component, thereby reducing costs, and allowing for high-density arrangement of second capacitors. In addition, a distance between the second capacitor in this application and the active region of the die is shorter than a distance between the on-package decoupling capacitor and the active region of the die. Therefore, the second capacitor in this application is more conducive to filtering out high-frequency noise. The distance between the second capacitor in this application and the active region of the die is shorter than a distance between an on-board decoupling capacitor and the active region of the die. Therefore, the second capacitor in this application is more conducive to filtering out high-frequency noise.

On this basis, different capacitance requirements can be further met by designing a capacitance value of the first capacitor and a capacitance value of the second capacitor based on a series connection relationship between the first capacitor and the second capacitor.

In some possible implementations, the chip packaging structure further includes a first seed layer disposed between the die and the plurality of conductive bumps, and a second seed layer disposed between the electronic component and the plurality of conductive bumps; and the first capacitor is disposed between the first conductive bump and the first seed layer. In this way, the first seed layer and the second seed layer can be further used to prevent intermetallic reactions between materials of the plurality of conductive bumps and a first connection pad of the die and a second connection pad of the electronic component.

In some possible implementations, in a direction from the die to the electronic component, the first capacitor includes a first electrode, a first dielectric layer, and a second electrode, and the first conductive bump is reused as the second electrode. In a direction from the electronic component to the die, the second capacitor includes a third electrode, a second dielectric layer, and a fourth electrode, and the first conductive bump is further reused as the fourth electrode.

In some possible implementations, the electronic component is a package substrate, and the die is flip-chip packaged on the package substrate.

According to a second aspect, this application provides a flip chip packaging method, including: sequentially forming a first capacitor and a plurality of first bumps on a die to obtain a first substrate, where the die includes a first trace, the plurality of first bumps include a first sub-bump and a second sub-bump, and the first capacitor is located between the die and the first sub-bump; forming a plurality of second bumps on an electronic component to obtain a second substrate, where the electronic component includes a second trace and a third trace, and the plurality of second bumps include a third sub-bump and a fourth sub-bump; and performing alignment and bonding on the first substrate and the second substrate, where the first sub-bump is aligned with the third sub-bump, the second sub-bump is aligned with the fourth sub-bump, the first trace is electrically connected to the second trace through the first capacitor, the first sub-bump, and the third sub-bump, and the first trace is further electrically connected to the third trace through the second sub-bump and the fourth sub-bump; and first trace and the third trace are ground traces, and the second trace is a power supply trace; or the first trace and the third trace are power supply traces, and the second trace is a ground trace.

In some possible implementations, before forming the plurality of second bumps on the electronic component, the flip chip packaging method further includes: forming a second capacitor on the electronic component, where the second capacitor is located between the third sub-bump and the electronic component, and the first trace is electrically connected to the second trace through the first capacitor, the first sub-bump, the third sub-bump, and the second capacitor.

The second aspect and any one of the implementations of the second aspect respectively correspond to the first aspect and any one of the implementations of the first aspect. For technical effects corresponding to the second aspect and any one of the implementations of the second aspect, refer to technical effects corresponding to the first aspect and any one of the implementations of the first aspect. Details are not described herein again.

The foregoing describes a case in which a first conductive bump and a second conductive bump are electrically connected to a same first trace on the die. In some other possible implementations, the first conductive bump and the second conductive bump may also be electrically connected to a same trace on a package substrate. For details, refer to the third aspect and the fourth aspect of the specification.

According to a third aspect, this application provides a chip packaging structure, where the chip packaging structure includes a die, an electronic component, a plurality of conductive protrusions, and a first capacitor. The die includes a first trace and a second trace, and the electronic component includes a third trace. The plurality of conductive bumps are disposed between the die and the electronic component, and the plurality of conductive bumps include a first conductive bump and a second conductive bump. The first capacitor is disposed between the die and the first conductive bump, the first trace is electrically connected to the third trace through the first capacitor and the first conductive bump, and the second trace is electrically connected to the third trace through the second conductive bump. The first trace is a ground trace, and the second trace and the third trace are power supply traces; or the first trace is a power supply trace, and the second trace and the third trace are ground traces.

The first capacitor in this application is used as a decoupling capacitor, and the first capacitor is disposed between the die and the first conductive bump by occupying a part of an original position of the first conductive bump. In addition, the first capacitor is further electrically connected to the third trace through the first conductive bump, so that the first capacitor is electrically connected between the power supply trace and the ground trace. Compared with an on-die decoupling capacitor, the first capacitor in this application does not need to occupy resources on the die, thereby reducing costs. Compared with an on-package decoupling capacitor, the first capacitor in this application does not affect a trace of the electronic component, thereby reducing costs, and allowing for high-density arrangement of first capacitors. In addition, a distance between the first capacitor in this application and an active region of the die is shorter than a distance between the on-package decoupling capacitor and the active region of the die. Therefore, the first capacitor in this application is more conducive to filtering out high-frequency noise. The distance between the first capacitor in this application and the active region of the die is shorter than a distance between an on-board decoupling capacitor and the active region of the die. Therefore, the first capacitor in this application is more conducive to filtering out high-frequency noise.

In some possible implementations, the electronic component further includes a fourth trace, the plurality of conductive bumps further include a third conductive bump, and the fourth trace is electrically connected to the first trace through the third conductive bump. Both the first trace and the fourth trace are ground traces; or both the first trace and the fourth trace are power supply traces. In this way, for example, one transistor is electrically connected between a power supply trace and a ground trace, the first capacitor is electrically connected between the power supply trace and the ground trace, a drain of the transistor is electrically connected to the ground trace, and a source of the transistor is electrically connected to the power supply trace.

In some possible implementations, there are a plurality of first capacitors and a plurality of first conductive bumps, and the plurality of first capacitors are connected in parallel between the first trace and the third trace. In this way, different capacitance requirements can be further met by designing respective capacitance values of two first capacitors based on a parallel connection relationship between the two first capacitors.

In some possible implementations, the chip packaging structure further includes a second capacitor. The second capacitor is disposed between the first conductive bump and the electronic component, and the first trace is electrically connected to the third trace through the first capacitor, the first conductive bump, and the second capacitor.

Compared with an on-die decoupling capacitor, the second capacitor in this application does not need to occupy resources on the die, thereby reducing costs. Compared with an on-package decoupling capacitor, the second capacitor in this application does not affect a trace of the electronic component, thereby reducing costs, and allowing for high-density arrangement of second capacitors. In addition, a distance between the second capacitor in this application and the active region of the die is shorter than a distance between the on-package decoupling capacitor and the active region of the die. Therefore, the second capacitor in this application is more conducive to filtering out high-frequency noise. The distance between the second capacitor in this application and the active region of the die is shorter than a distance between an on-board decoupling capacitor and the active region of the die. Therefore, the second capacitor in this application is more conducive to filtering out high-frequency noise.

On this basis, different capacitance requirements can be further met by designing a capacitance value of the first capacitor and a capacitance value of the second capacitor based on a series connection relationship between the first capacitor and the second capacitor.

In some possible implementations, the chip packaging structure further includes a first seed layer disposed between the die and the plurality of conductive bumps, and a second seed layer disposed between the electronic component and the plurality of conductive bumps; and the first capacitor is disposed between the first conductive bump and the seed layer. In this way, the first seed layer and the second seed layer can be further used to prevent intermetallic reactions between materials of the plurality of conductive bumps and a first connection pad of the die and a second connection pad of the electronic component.

In some possible implementations, the electronic component is a package substrate, and the die is flip-chip packaged on the package substrate.

According to a fourth aspect, this application provides a flip chip packaging method, including: sequentially forming a first capacitor and a plurality of first bumps on a die to obtain a first substrate, where the die includes a first trace and a second trace, the plurality of first bumps include a first sub-bump and a second sub-bump, and the first capacitor is located between the die and the first sub-bump; forming a plurality of second bumps on an electronic component to obtain a second substrate, where the electronic component includes a third trace, and the plurality of second bumps include a third sub-bump and a fourth sub-bump; and performing alignment and bonding on the first substrate and the second substrate, where the first sub-bump is aligned with the third sub-bump, the second sub-bump is aligned with the fourth sub-bump, the first trace is electrically connected to the third trace through the first capacitor, the first sub-bump, and the third sub-bump, and the second trace is electrically connected to the third trace through the second sub-bump and the fourth sub-bump; and the first trace is a ground trace, and the second trace and the third trace are power supply traces; or the first trace is a power supply trace, and the second trace and the third trace are ground traces.

In some possible implementations, before forming the plurality of second bumps on the electronic component, the flip chip packaging method further includes: forming a second capacitor on the electronic component, where the second capacitor is located between the third sub-bump and the electronic component, and the first trace is electrically connected to the third trace through the first capacitor, the first sub-bump, the third sub-bump, and the second capacitor.

Any one of the fourth aspect and the implementations of the fourth aspect corresponds to any one of the third aspect and the implementations of the third aspect. For technical effects corresponding to the fourth aspect and any implementation of the fourth aspect, refer to the technical effects corresponding to the third aspect and any implementation of the third aspect. Details are not described herein again.

According to a fifth aspect, this application provides an electronic device, where the electronic device includes a circuit board, a solder ball, and the chip packaging structure according to the first aspect or the third aspect, and the electronic component of the chip packaging structure is soldered to the circuit board through the solder ball.

The fifth aspect and any implementation of the fifth aspect respectively correspond to the first aspect and any implementation of the first aspect or the third aspect and any implementation of the third aspect. For technical effects corresponding to the fifth aspect and any implementation of the fifth aspect, refer to the technical effects corresponding to the first aspect, the third aspect, any implementation of the first aspect, and any implementation of the third aspect. Details are not described herein again.

### BRIEF DESCRIPTION OF DRAWINGS

FIG. 1a is a top view of a die according to an embodiment of this application;
FIG. 1b is a diagram of a connection relationship between a chip packaging structure and a circuit board according to a related technology;
FIG. 2 is a diagram of disposing positions of decoupling capacitors according to a related technology;
FIG. 3a is a diagram of a chip packaging structure according to an embodiment of this application;
FIG. 3b is a circuit diagram corresponding to the chip packaging structure shown in FIG. 3a;
FIG. 3c is a diagram of a chip packaging structure according to an embodiment of this application;
FIG. 3d is a circuit diagram corresponding to the chip packaging structure shown in FIG. 3c;
FIG. 4a is a diagram of a chip packaging structure according to an embodiment of this application;
FIG. 4b is a circuit diagram corresponding to the chip packaging structure shown in FIG. 4a;
FIG. 4c is a diagram of a chip packaging structure according to an embodiment of this application;
FIG. 4d is a circuit diagram corresponding to the chip packaging structure shown in FIG. 4c;
FIG. 5a is a diagram of a chip packaging structure according to an embodiment of this application;
FIG. 5b is a diagram of a chip packaging structure according to an embodiment of this application;
FIG. 6a is a diagram of a chip packaging structure according to an embodiment of this application;
FIG. 6b is a diagram of a first capacitor and a second capacitor according to an embodiment of this application;
FIG. 6c is a diagram of a first capacitor and a second capacitor according to an embodiment of this application;
FIG. 6d is a cross-sectional view in an A1-A2 direction in FIG. 6c;
FIG. 7 is a diagram of a chip packaging structure according to an embodiment of this application;
FIG. 8 is a diagram of a chip packaging structure according to an embodiment of this application;
FIG. 9 is a flowchart of fabrication for a chip packaging structure according to an embodiment of this application;
FIG. 10a to FIG. 10h are process diagrams of forming a first capacitor and a first bump on a die according to an embodiment of this application;
FIG. 11a to FIG. 11c are process diagrams of forming a second bump on a package substrate according to an embodiment of this application; and
FIG. 12a to FIG. 12e are process diagrams of forming a second capacitor and a second bump on a package substrate according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and so on are intended to distinguish between different objects but do not indicate a particular order of the objects. For example, a first target object and a second target object are used to distinguish between different target objects, but are not used to describe a particular order of the target objects.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word "example", "for example", or the like is intended to present a related concept in a specific manner.

In descriptions of embodiments of this application, unless otherwise stated, "a plurality of" means two or more than two. For example, a plurality of processing units mean two or more processing units, and a plurality of systems mean two or more systems.

An embodiment of this application provides an electronic device. The electronic device may be a device including a chip, for example, a consumer electronic product, a home electronic product, a vehicle-mounted electronic product, a financial terminal product, or a communication electronic product.

For example, the consumer electronic product is a mobile phone (mobile phone), a tablet computer (tablet computer), a notebook computer, a personal computer (personal computer, PC), a personal digital assistant (personal digital assistant, PDA), a smart wearable product (for example, a smart watch or a smart band), a virtual reality (virtual reality, VR) terminal device, an augmented reality (augmented reality, AR) terminal device, or an uncrewed aerial vehicle. For example, the home electronic product is a smart door lock, a television, a smart speaker, a refrigerator, and a robotic vacuum cleaner. For example, the vehicle-mounted electronic product is a vehicle-mounted navigator or a vehicle-mounted display. The financial terminal product is, for example, an automated teller machine (automated teller machine, ATM) or a terminal for self-help service handling. For example, the communication electronic product is a device including a chip, for example, a communication device like a server, a memory, a radar, or a base station.

For ease of description, the following uses an example in which the electronic device is a mobile phone for description. The mobile phone may include a circuit board. A processor, a memory, and the like may be integrated on the circuit board. For example, the processor may be implemented through a circuit connection on one or more chips. Certainly, the mobile phone may further include another component, and another circuit structure may be further integrated on the circuit board. This is not limited in embodiments of this application.

With increased chip interconnection density and continuous reduction in sizes of interconnection components, chip packaging technologies are increasingly diversified. Because a flip chip packaging technology can shorten an interconnection length in a package, and can better meet development requirements of high integration, the flip chip packaging technology has been widely applied to the chip packaging field. In the flip chip packaging, a conductive bump is directly manufactured on a die as a connection terminal, and is flip-chip soldered to a package substrate, so that the die is electrically connected to the package substrate.

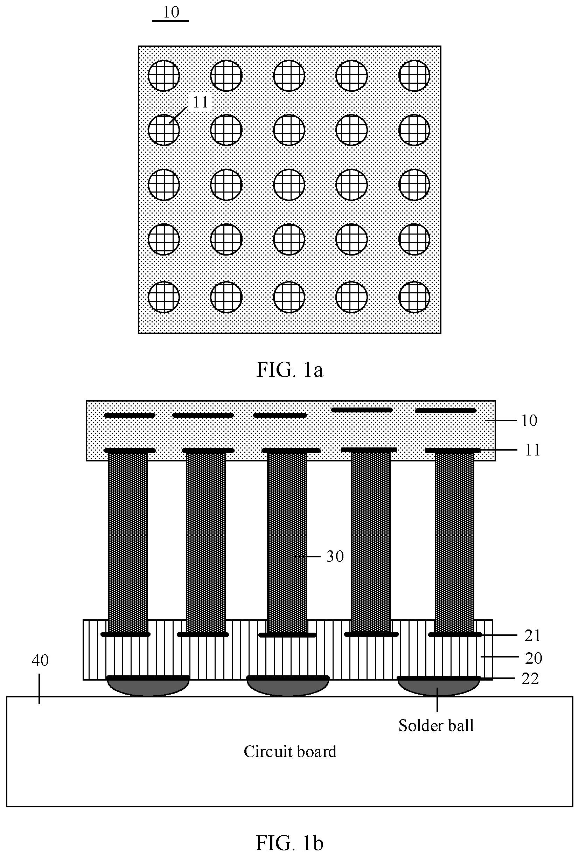

Specifically, FIG. 1a shows a top view of a die 10. The die 10 includes a first connection pad 11, and the first connection pad 11 may also be referred to as a soldering pad or another name. As shown in FIG. 1b, the die 10 is flip-mounted on a package substrate 20, and a conductive bump 30 is in contact with both the first connection pad 11 of the die 10 and a second connection pad 21 of the package substrate 20, so that the first connection pad 11 is electrically connected to the second connection pad 21 through the conductive bump 30, and the first connection pad 11 on the die 10 is led out to the second connection pad 21 of the package substrate 20 through the conductive bump 30.

As shown in FIG. 1b, the package substrate 20 further includes a third connection pad 22 opposite to the second connection pad 21, the second connection pad 21 is electrically connected to the third connection pad 22 through a routing layer in the package substrate 20, and the die 10 is soldered to a circuit board 40 through the third connection pad 22 and a solder ball in the package substrate 20.

As mentioned in the background, as the rate, power consumption, and complexity of a chip increase, power integrity (power integrity, PI) of the chip gradually becomes a key bottleneck for overall functionality and performance of the chip, resulting in an increased demand for decoupling capacitors (decaps) on the chip. Based on placement positions of decoupling capacitors, the decoupling capacitors are classified into the following types: on-die decoupling capacitors, on-package decoupling capacitors, and on-board decoupling capacitors.

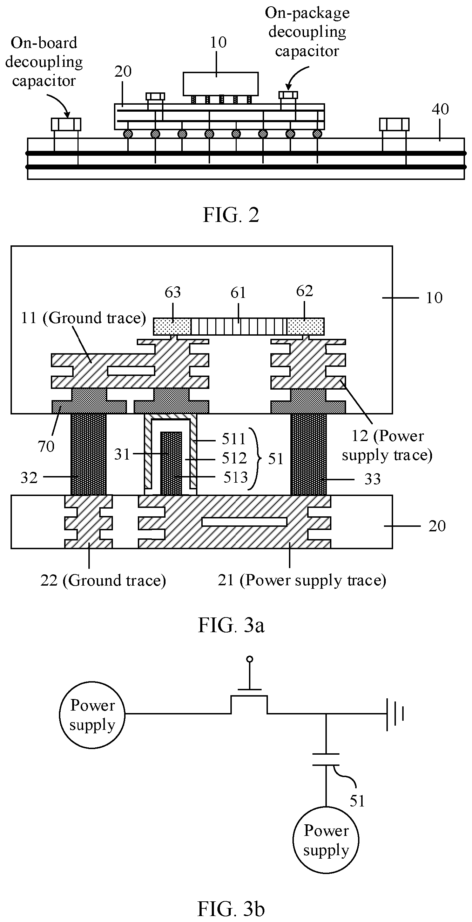

The on-die decoupling capacitor is formed in a back end of line (back end of line, BEOL) of the die. As shown in FIG. 2, an on-package decoupling capacitor usually refers to a surface capacitor or a backside capacitor disposed on a package substrate 20. As shown in FIG. 2, an on-board decoupling capacitor is disposed on a circuit board 40.

However, an on-die decoupling capacitor occupies resources on a die 10, resulting in high costs. The on-package decoupling capacitor affects a trace on the package substrate 20, and increases assembly costs of the package substrate 20, and decoupling capacitor density is low. In addition, the decoupling capacitor is far away from an active region of the die 10, which is not conducive to filtering out high-frequency noise. A filtering range of the on-board decoupling capacitor is limited, and low-frequency noise is mainly filtered out. The active region is a region, of the die 10, in which a transistor manufactured by using a front end of line is located.

However, as the rate, power consumption, and complexity of the chip increase, high-frequency noise in a power delivery network becomes more serious. A cost-effective decoupling capacitor solution to address high-frequency noise has become a research hotspot.

In view of this, an embodiment of this application provides a chip packaging structure. The chip packaging structure may be applied to a circuit that needs to filter out high-frequency noise, for example, a power delivery network and a signal isolation circuit.

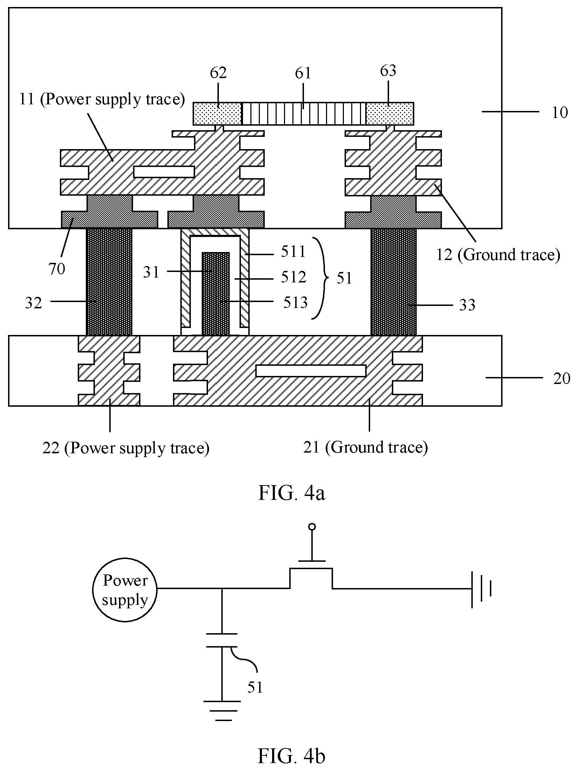

As shown in FIG. 3a and FIG. 4a, the chip packaging structure includes a die 10, an electronic component, a plurality of conductive bumps 30, and a first capacitor 51. The electronic component may be a package substrate 20, an integrated passive device (integrated passive device, IPD), or the like. For ease of description, the following uses an example in which the electronic component is the package substrate 20 for description.

The die 10 includes a first trace 11, and the package substrate 20 includes a second trace 21 and a third trace 22. The plurality of conductive bumps 30 are disposed between the die 10 and the package substrate 20, and the plurality of conductive bumps 30 include a first conductive bump 31 and a second conductive bump 32. The first capacitor 51 is disposed between the die 10 and the first conductive bump 31. In other words, the first capacitor 51 is a part of the first conductive bump 31, and in the first conductive bump 31, the first capacitor 51 is closer to the die 10.

The first trace 11 is electrically connected to the second trace 21 through the first capacitor 51 and the first conductive bump 31, and the first trace 11 is further electrically connected to the third trace 22 through the second conductive bump 32. As shown in FIG. 3a, the first trace 11 and the third trace 22 are ground traces, and the second trace 21 is a power supply trace. Alternatively, as shown in FIG. 4a, the first trace 11 and the third trace 22 are power supply traces, and the second trace 21 is a ground trace.

The first capacitor 51 in this application is used as a decoupling capacitor, and the first capacitor 51 is disposed between the die 10 and the first conductive bump 31 by occupying a part of an original position of the first conductive bump 31. In addition, the first capacitor 51 is further electrically connected to the second trace 21 through the first conductive bump 31, so that the first capacitor 51 is electrically connected between the power supply trace and the ground trace. Compared with an on-die decoupling capacitor, the first capacitor 51 in this application does not need to occupy resources on the die, thereby reducing costs. Compared with an on-package decoupling capacitor, the first capacitor 51 in this application does not affect a trace of the package substrate 20, thereby reducing costs, and allowing for high-density arrangement of first capacitors. In addition, a distance between the first capacitor 51 in this application and an active region of the die 10 is shorter than a distance between the on-package decoupling capacitor and the active region of the die 10. Therefore, the first capacitor 51 in this application is more conducive to filtering out high-frequency noise. The distance between the first capacitor 51 in this application and the active region of the die 10 is shorter than a distance between an on-board decoupling capacitor and the active region of the die 10. Therefore, the first capacitor 51 in this application is more conducive to filtering out high-frequency noise.

In addition, the die 10 may further include a plurality of transistors and a conductive lead 70. The transistor includes a channel layer 61, a source 62, and a drain 63.

For example, one transistor is electrically connected between a power supply trace and a ground trace. As shown in FIG. 3a and FIG. 3b, if the first trace 11 and the third trace 22 are ground traces, and the second trace 21 is a power supply trace, the drain 63 of the transistor is electrically connected to different conductive bumps through a same ground trace on the die 10. Specifically, the ground trace on the die 10 is electrically connected to a ground trace on the package substrate 20 through the conductive lead 70 and the second conductive bump 32, and the ground trace on the die 10 is also electrically connected to a power supply trace on the package substrate 20 through the conductive lead 70, the first capacitor 51, and the first conductive bump 31. In this way, the first capacitor 51 is electrically connected between the power supply trace and the ground trace, and the drain 63 of the transistor is electrically connected to the ground trace. In this embodiment of this application, the power supply in the circuit diagram represents a power supply trace.

On this basis, as shown in FIG. 3a and FIG. 3b, the die 10 further includes a fourth trace 22, and the fourth trace 22 is a power supply trace. The plurality of conductive bumps further include a third conductive bump 33, and the source 62 of the transistor is electrically connected to the power supply trace on the package substrate 20 through the power supply trace and the conductive lead 70 of the die 10 and the third conductive bump 33. In this way, the source 62 of the transistor is electrically connected to the power supply trace. The power supply trace that is on the package substrate 20 and that is electrically connected to the first conductive bump 31 and the trace that is on the package substrate 20 and that is electrically connected to the third conductive bump 31 are the same second trace 21.

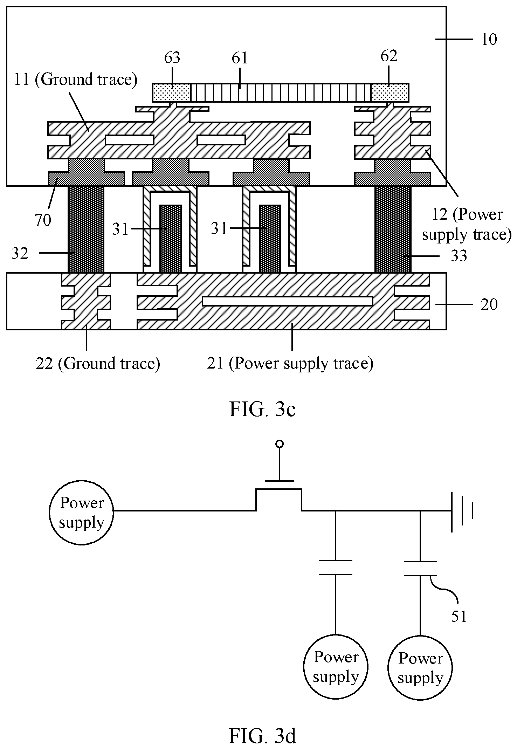

In some possible implementations, as shown in FIG. 3a and FIG. 3b, there is one first conductive bump 31 and one first capacitor 51; or as shown in FIG. 3c and FIG. 3d, there are a plurality of first conductive bumps 31 and a plurality of first capacitors 51. For example, there are two first conductive bumps 31 and two first capacitors 51, and the two first capacitors 51 are connected in parallel between the ground trace and the power supply trace. In this way, different capacitance requirements can be further met by designing respective capacitance values of the two first capacitors 51 based on a parallel connection relationship between the two first capacitors 51.

One transistor being electrically connected between a power supply trace and a ground trace is still used as an example. As shown in FIG. 4a and FIG. 4b, if the first trace 11 and the third trace 22 are power supply traces, and the second trace 21 is a ground trace, the source 62 of the transistor is electrically connected to different conductive bumps through a same power supply trace on the die 10. Specifically, the power supply trace on the die 10 is electrically connected to a power supply trace on the package substrate 20 through the conductive lead 70 and the second conductive bump 32, and the power supply trace on the die 10 is also electrically connected to a ground trace on the package substrate 20 through the conductive lead 70, the first capacitor 51, and the first conductive bump 31. In this way, the first capacitor 51 is electrically connected between the power supply trace and the ground trace, and the source 62 of the transistor is electrically connected to the power supply trace.

On this basis, as shown in FIG. 4a and FIG. 4b, the die 10 further includes a fourth trace 22, and the fourth trace 22 is a ground trace. The plurality of conductive bumps further include a third conductive bump 33, and the drain of the transistor is electrically connected to the ground trace on the package substrate 20 through the ground trace and the conductive lead 70 of the die 10 and the third conductive bump 33. In this way, the drain 63 of the transistor is electrically connected to the ground trace. The ground trace that is on the package substrate 20 and that is electrically connected to the first conductive bump 31 and the ground trace that is on the package substrate 20 and that is electrically connected to the third conductive bump 31 are the same second trace 21.

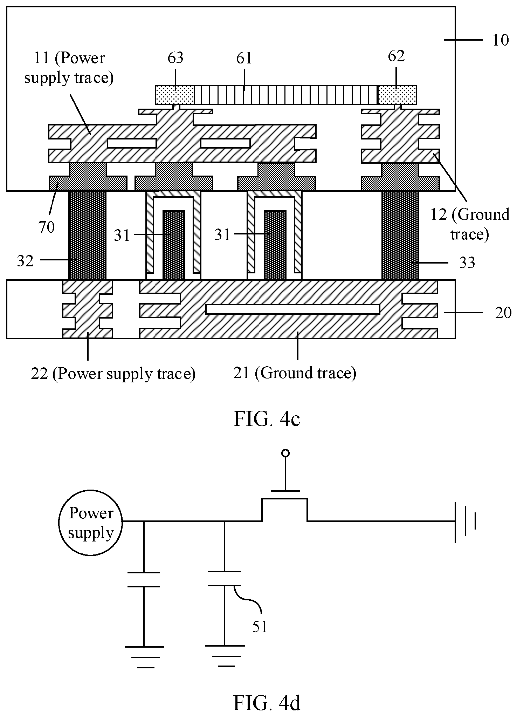

In some possible implementations, as shown in FIG. 4a and FIG. 4b, there is one first conductive bump 31 and one first capacitor 51; or as shown in FIG. 4c and FIG. 4d, there are a plurality of first conductive bumps 31 and a plurality of first capacitors 51. For example, there are two first conductive bumps 31 and two first capacitors 51, and the two first capacitors 51 are connected in parallel between the ground trace and the power supply trace. In this way, different capacitance requirements can be further met by designing respective capacitance values of the two first capacitors 51 based on a parallel connection relationship between the two first capacitors 51.

The foregoing example describes that one transistor is electrically connected between the power supply trace and the ground trace. Certainly, another circuit may be electrically connected between the power supply trace and the ground trace. This is not limited in this embodiment of this application.

In some embodiments, as shown in FIG. 4a, the first capacitor 51 includes a first electrode 511, a first dielectric layer 512, and a second electrode 513. In a direction from the die 10 to the package substrate 20, the first electrode 511, the first dielectric layer 512, and the second electrode 513 are sequentially stacked. Because both the second electrode 513 and the first conductive bump 31 include a conductive material, the first conductive bump 31 may be reused as the second electrode 513.

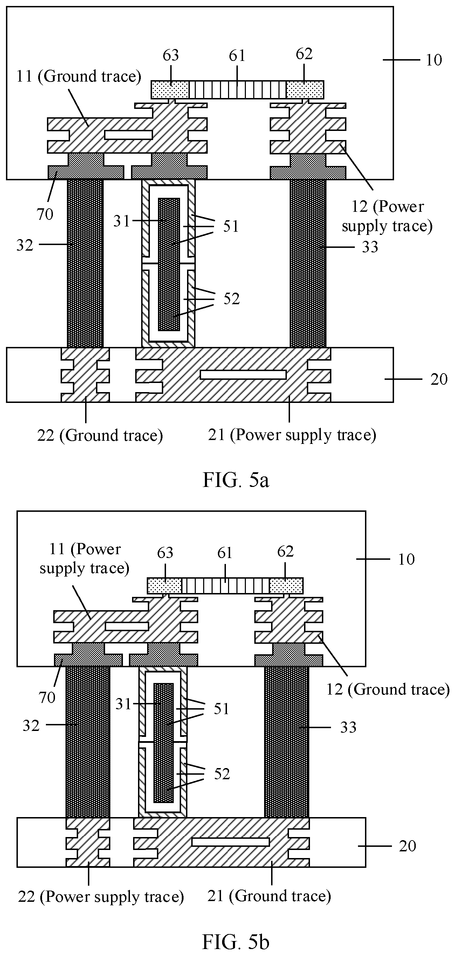

The foregoing describes a case in which the first capacitor 51 is disposed between the die 10 and the first conductive bump 31. In some other embodiments, as shown in FIG. 5a and FIG. 5b, the chip packaging structure may further include a second capacitor 52. The second capacitor 52 is disposed between the first conductive bump 31 and the package substrate 20. In other words, the second capacitor 52 is a part of the first conductive bump 31, and in the first conductive bump 31, the second capacitor 51 is closer to the package substrate 20. The first trace 11 is electrically connected to the second trace 21 through the first capacitor 51, the first conductive bump 31, and the second capacitor 52.

Compared with an on-die decoupling capacitor, the second capacitor 52 in this application does not need to occupy resources on the die, thereby reducing costs. Compared with an on-package decoupling capacitor, the second capacitor 52 in this application does not affect a trace of the package substrate 20, thereby reducing costs, and allowing for high-density arrangement of second capacitors 52. In addition, a distance between the second capacitor 52 in this application and the active region of the die 10 is shorter than a distance between the on-package decoupling capacitor and the active region of the die 10. Therefore, the second capacitor 52 in this application is more conducive to filtering out high-frequency noise. The distance between the second capacitor 52 in this application and the active region of the die 10 is shorter than a distance between an on-board decoupling capacitor and the active region of the die 10. Therefore, the second capacitor 52 in this application is more conducive to filtering out high-frequency noise.

On this basis, different capacitance requirements can be further met by designing a capacitance value of the first capacitor 51 and a capacitance value of the second capacitor 52 based on a series connection relationship between the first capacitor 51 and the second capacitor 52.

For example, one transistor is electrically connected between a power supply trace and a ground trace. As shown in FIG. 5a, if the first trace 11 and the third trace 22 are ground traces, and the second trace 21 is a power supply trace, the drain 63 of the transistor is electrically connected to different conductive bumps through a same ground trace on the die 10. Specifically, the ground trace on the die 10 is electrically connected to a ground trace on the package substrate 20 through the conductive lead 70 and the second conductive bump 32, and the ground trace on the die 10 is also electrically connected to a power supply trace on the package substrate 20 through the conductive lead 70, the first capacitor 51, the first conductive bump 31, and the second capacitor 51. In this way, the first capacitor 51 is electrically connected between the power supply trace and the ground trace, and the drain 63 of the transistor is electrically connected to the ground trace.

One transistor being electrically connected between a power supply trace and a ground trace is still used as an example. As shown in FIG. 5b, if the first trace 11 and the third trace 22 are power supply traces, and the second trace 21 is a ground trace, the source 62 of the transistor is electrically connected to different conductive bumps through a same power supply trace on the die 10. Specifically, the power supply trace on the die 10 is electrically connected to a power supply trace on the package substrate 20 through the conductive lead 70 and the second conductive bump 32, and the power supply trace on the die 10 is also electrically connected to a ground trace on the package substrate 20 through the conductive lead 70, the first capacitor 51, the first conductive bump 31, and the second capacitor 52. In this way, the first capacitor 51 is electrically connected between the power supply trace and the ground trace, and the source 62 of the transistor is electrically connected to the power supply trace.

In some possible implementations, specific structures of the first capacitor 51 and the second capacitor 52 are not limited in this embodiment of this application, provided that the first capacitor 51 includes a first electrode 511, a first dielectric layer 512, and a second electrode 513 that are sequentially stacked, and the second capacitor 52 includes a third electrode, a second dielectric layer, and a fourth electrode that are sequentially stacked.

Optionally, as shown in FIG. 5a and FIG. 5b, in a direction from the die 10 to the package substrate 20, the first electrode 511, the first dielectric layer 512, and the second electrode 513 are sequentially stacked, the first electrode 511 and the first dielectric layer 512 are in a concave shape, and the second electrode 513 is located in a groove of the concave shape; and in a direction from the package substrate 20 to the die 10, the third electrode 521, the second dielectric layer 522, and the fourth electrode 523 are sequentially stacked, the third electrode 521 and the second dielectric layer 522 are in a concave shape, and the fourth electrode 523 is located in a groove of the concave shape.

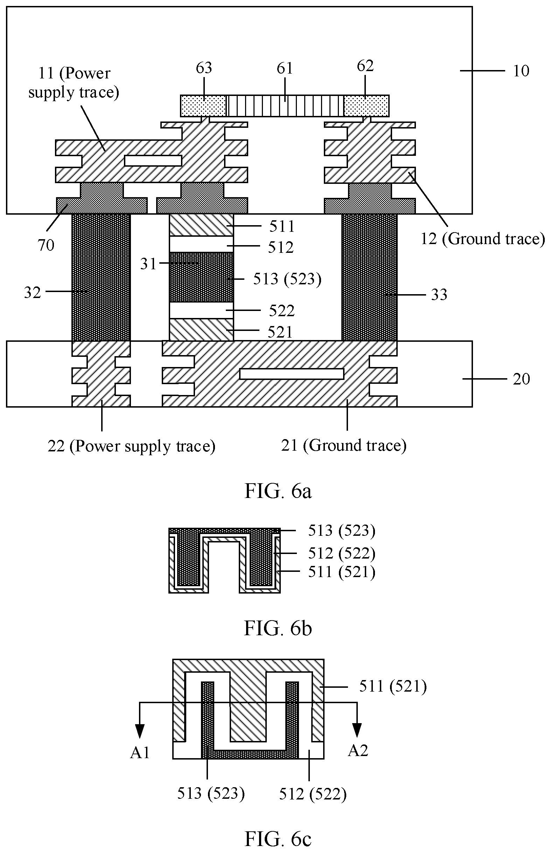

Optionally, as shown in FIG. 6a, in a direction from the die 10 to the package substrate 20, the first electrode 511, the first dielectric layer 512, and the second electrode 513 are sequentially stacked, and the first electrode 511, the first dielectric layer 512, and the second electrode 513 are all plate-shaped; and in a direction from the package substrate 20 to the die 10, the third electrode 521, the second dielectric layer 522, and the fourth electrode 523 are sequentially stacked, and the third electrode 521, the second dielectric layer 522, and the fourth electrode 523 are all plate-shaped.

Optionally, as shown in FIG. 6b, in a direction from the die 10 to the package substrate 20, the first electrode 511, the first dielectric layer 512, and the second electrode 513 are sequentially stacked, each of the first electrode 511 and the first dielectric layer 512 includes a plurality of grooves, and the second electrode 513 is located in the plurality of grooves; and in a direction from the package substrate 20 to the die 10, the third electrode 521, the second dielectric layer 522, and the fourth electrode 523 are sequentially stacked, each of the third electrode 521 and the second dielectric layer 522 include a plurality of grooves, and the fourth electrode 523 is located in the plurality of grooves.

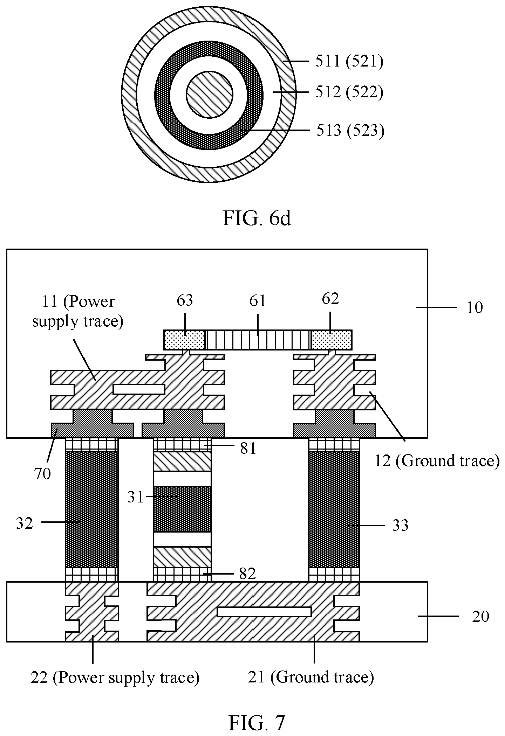

As shown in FIG. 6c and FIG. 6d, in a direction from the second conductive bump 32 to the first conductive bump 31, the first electrode 511, the first dielectric layer 512, and the second electrode 513 are sequentially stacked and are in a circular ring shape; and in a direction from the second conductive bump 32 to the first conductive bump 31, the third electrode 521, the second dielectric layer 522, and the fourth electrode 523 are sequentially stacked and are in a circular ring shape. In the first capacitor 51, there may be one or more first electrodes 511, first dielectric layers 512, and second electrodes 513; and in the second capacitor 52, there may be one or more third electrodes 521, second dielectric layers 522, and fourth electrodes 523. When there are a plurality of first electrodes 511, the plurality of first electrodes 511 are electrically connected. When there are a plurality of second electrodes 513, the plurality of second electrodes 513 are electrically connected. When there are a plurality of third electrodes 521, the plurality of third electrodes 521 are electrically connected. When there are a plurality of fourth electrodes 523, the plurality of fourth electrodes 523 are electrically connected.

In some embodiments, if intermetallic reactions occur between materials of the plurality of conductive bumps and materials of a second connection pad of a redistribution layer 20 and a first connection pad of the die 10 to form intermetallic compounds, this may cause phase transformations in the second connection pad of the redistribution layer 20 and the first connection pad of the die 10, leading to shrinkage and collapse, thereby significantly reducing soldering reliability of the plurality of conductive bumps.

For example, materials of the first connection pad and the second connection pad are copper (Cu), materials of the plurality of conductive bumps include tin (Sn), and copper and tin react to generate a copper-tin intermetallic compound.

As shown in FIG. 7, the chip packaging structure further includes a first seed layer 81 disposed between the die 10 and a plurality of conductive protrusions, and a second seed layer 82 disposed between the package substrate 20 and the plurality of conductive protrusions. The first capacitor 51 is disposed between the first conductive bump 31 and the first seed layer 81, and the second capacitor 52 is disposed between the first conductive bump 31 and the second seed layer 82. In this way, the first seed layer 81 and the second seed layer 82 can be further used to prevent intermetallic reactions between the materials of the plurality of conductive bumps and the first connection pad of the die 10 and the second connection pad of the package substrate 20.

In addition, to ensure that the second connection pad of the package substrate 20 is electrically connected to the first connection pad of the die 10, materials of both the first seed layer 81 and the second seed layer 82 include a conductive material, so that the second connection pad of the package substrate 20 is electrically connected to the first connection pad of the die 10 through the first seed layer 81, the plurality of conductive bumps, and the second seed layer 82. Optionally, the first seed layer 81 and the second seed layer 82 may be a stack of a titanium (Ti) layer and a Cu layer.

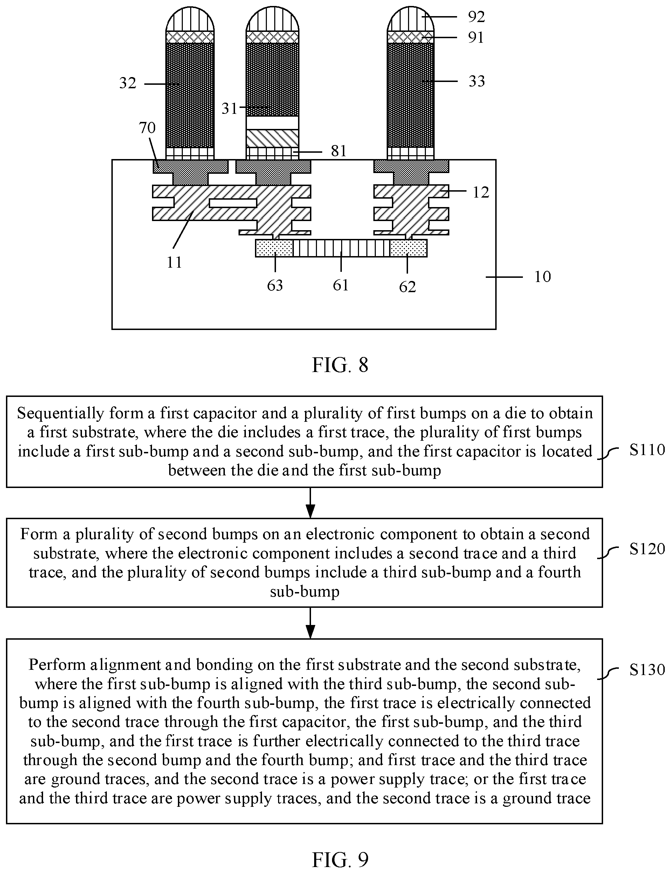

In some embodiments, as shown in FIG. 8, the plurality of conductive bumps may include a stack of a titanium (Ti)/titanium nitride (TiN) layer and a copper (Cu) layer, and the Cu layer is located on a side, of the Ti/TiN layer, away from the die 10. On this basis, the chip packaging structure may further include a tin (Sn) layer (or an SnAg layer) 92, and the Sn layer 92 is disposed on a side, of the Cu layer, away from the die 10.

To prevent Cu diffusion on the Cu layer and better bond the Sn layer 92, the chip packaging structure may further include a nickel (Ni) layer 91, where the Ni layer 91 is located between the Cu layer and the Sn layer 92.

In another embodiment, this application provides a flip chip packaging method. As shown in FIG. 9, the method may be implemented by using the following steps.

S110: Sequentially form a first capacitor 51 and a plurality of first bumps on a die 10 to obtain a first substrate, where the die 10 includes a first trace 11, the plurality of first bumps include a first sub-bump and a second sub-bump, and the first capacitor 51 is located between the die 10 and the first sub-bump.

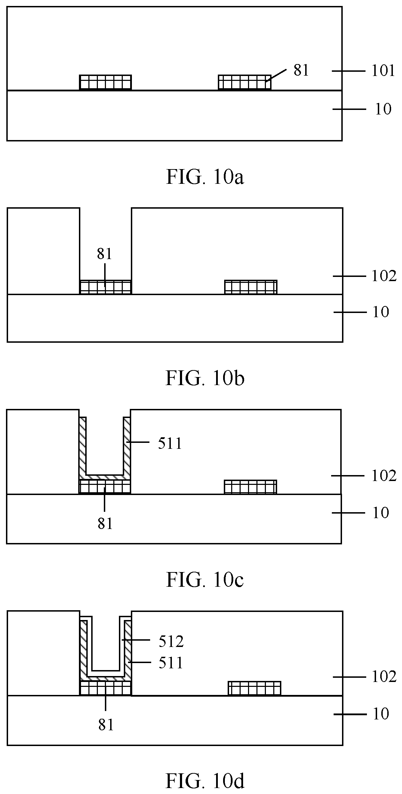

Specifically, as shown in FIG. 10a, before the first capacitor 51 is formed, a first seed layer 81 may be first formed on the die 10, and a first photoresist 101 may be formed on the first seed layer 81. As shown in FIG. 10b, the first photoresist 101 is exposed and developed to obtain a first photoresist pattern 102, where the first photoresist pattern 102 exposes a region in which the to-be-formed first sub-bump is located. In addition, the first photoresist pattern 102 covers a region in which the to-be-formed second sub-bump is located.

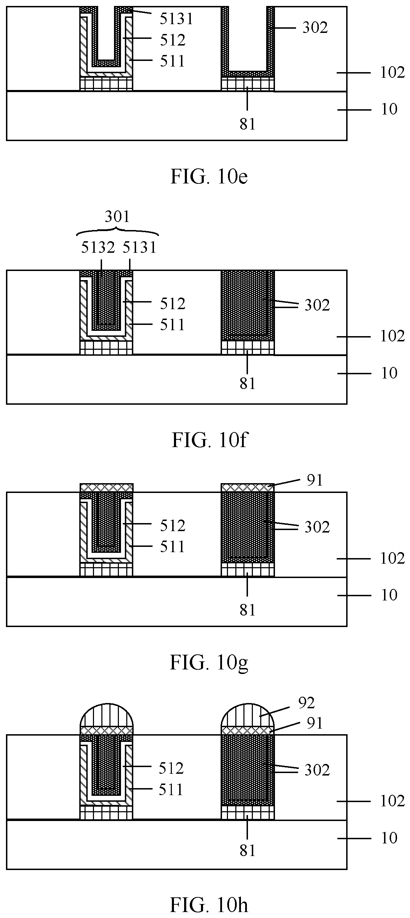

Then, the first capacitor 51 is formed on the first seed layer 81 under protection of the first photoresist pattern 102. That is, as shown in FIG. 10c to FIG. 10f, a first electrode 511, a first dielectric layer 512, and a second electrode 513 are sequentially formed on the first seed layer 81. As shown in FIG. 10e, first, a part of the second electrode 5131 may be deposited by using atomic layer deposition (atomic layer deposition, ALD), and then, as shown in FIG. 10f, the other part of the second electrode 5132 is deposited by using chemical vapor deposition (chemical vapor deposition, CVD). The second electrode 5131 and the second electrode 5132 together form the second electrode 513.

In some possible implementations, the second electrode 513 is reused as a first sub-bump 301, and forming the second electrode 513 is equivalent to forming the first sub-bump 301.

In some possible implementations, as shown in FIG. 10e and FIG. 10f, when the second electrode 513 is reused as the first sub-bump 301, after the first dielectric layer 512 is formed and before the second electrode 513 is formed, the first photoresist pattern 102 may be further exposed, and the developed first photoresist pattern 102 further exposes the region in which the to-be-formed second sub-bump is located. In this way, a second sub-bump 302 can also be deposited while depositing the second electrode 5131 and the second electrode 5132. Then, as shown in FIG. 10g and FIG. 10h, a Ni layer 91 and an Sn layer (or an SnAg layer) 92 may be sequentially formed on the plurality of first bumps.

S120: Form a plurality of second bumps on a package substrate 20 to obtain a second substrate, where the package substrate 20 includes a second trace 21 and a third trace 22, and the plurality of second bumps include a third sub-bump and a fourth sub-bump.

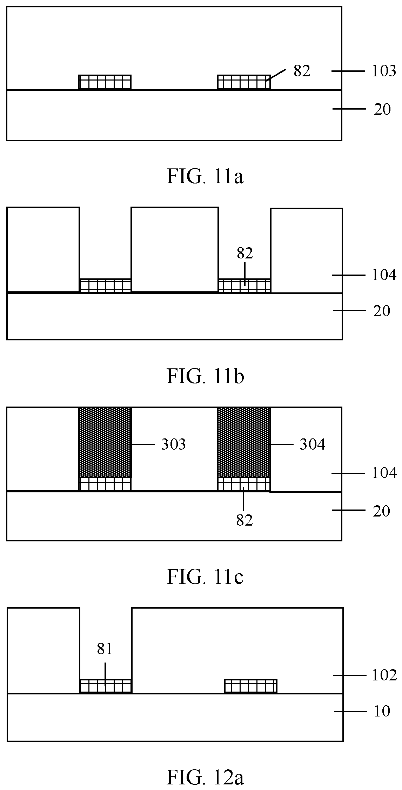

Specifically, as shown in FIG. 11a, a second seed layer 82 may be first formed on the die 10, and a second photoresist 103 may be formed on the second seed layer 82. As shown in FIG. 11b, the second photoresist 103 is exposed and developed to obtain a second photoresist pattern 104, where the second photoresist pattern 104 exposes a region in which the second bump is to be formed.

In some possible implementations, the package substrate 20 may be, for example, a silicon-based substrate or an interposer (interposer).

Then, as shown in FIG. 11c, the plurality of second bumps are formed under protection of the first photoresist pattern 102. The plurality of second bumps include a third sub-bump 303 and a fourth sub-bump 304.

S130: As shown in FIG. 3a, perform alignment and bonding on the first substrate and the second substrate, where the first sub-bump 301 is aligned with the third sub-bump 303, the second sub-bump 302 is aligned with the fourth sub-bump 304, the first trace 11 is electrically connected to the second trace 21 through the first capacitor 51, the first sub-bump 301, and the third sub-bump 303, and the first trace 11 is further electrically connected to the third trace 22 through the second sub-bump 302 and the fourth sub-bump 304; and first trace 11 and the third trace 22 are ground traces, and the second trace 21 is a power supply trace; or the first trace 11 and the third trace 22 are power supply traces, and the second trace 21 is a ground trace.

The third sub-bump 303 and the first sub-bump 301 are aligned and bonded to form a first conductive bump 31, and the fourth sub-bump 304 and the second sub-bump 302 are aligned and bonded to form a second conductive bump 32.

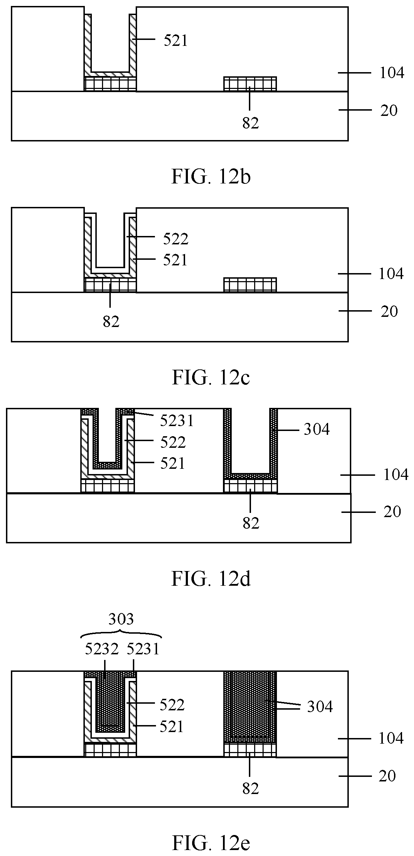

The foregoing describes a case in which the chip packaging structure includes the first capacitor 51. In some embodiments, the chip packaging structure further includes a second capacitor 52. Specifically, as shown in FIG. 12a, after the second seed layer 82 is formed and before step S120, the second photoresist 103 is exposed and developed to obtain the second photoresist pattern 104, and the second photoresist pattern 104 exposes a region in which the to-be-formed third sub-bump is located. In addition, the second photoresist pattern 104 covers a region in which the to-be-formed fourth sub-bump is located.

Then, the first capacitor 51 is formed on the second seed layer 82 under protection of the second photoresist pattern 104. That is, as shown in FIG. 12a to FIG. 10e, a third electrode 521, a second dielectric layer 522, and a fourth electrode 523 are sequentially formed on the second seed layer 82. As shown in FIG. 12d, first, a part of the fourth electrode 5231 may be deposited by using ALD, and then, as shown in FIG. 12e, the other part of the fourth electrode 5232 is deposited by using CVD. The fourth electrode 5231 and the fourth electrode 5232 together form the fourth electrode 523.

In some possible implementations, the fourth electrode 523 is reused as the third sub-bump 303, and forming the fourth electrode 523 is equivalent to forming the third sub-bump 303.

In some possible implementations, as shown in FIG. 12d and FIG. 12e, when the fourth electrode 523 is reused as the third sub-bump 303, after the second dielectric layer 522 is formed and before the fourth electrode 523 is formed, the second photoresist pattern 104 may be further exposed, and the developed second photoresist pattern 104 further exposes the region in which the to-be-formed fourth sub-bump is located. In this way, the fourth sub-bump 304 can also be deposited while depositing the fourth electrode 5231 and the fourth electrode 5232.

In addition, other explanations, descriptions, and beneficial effects of embodiments of this application are the same as those of the previous embodiment. Details are not described herein again.

The foregoing describes embodiments of this application with reference to the accompanying drawings. However, this application is not limited to the foregoing specific implementations. The foregoing specific implementations are merely examples, but are not limitative. Inspired by this application, a person of ordinary skill in the art may further make many modifications without departing from the purposes of this application and the protection scope of the claims, and all the modifications shall fall within protection of this application.

## Claims

1. A chip packaging structure, comprising a die, an electronic component, a plurality of conductive bumps, and a first capacitor, wherein
the die comprises a first trace, and the electronic component comprises a second trace and a third trace;
the plurality of conductive bumps are disposed between the die and the electronic component, and the plurality of conductive bumps comprise a first conductive bump and a second conductive bump;
the first capacitor is disposed between the die and the first conductive bump, the first trace is electrically connected to the second trace through the first capacitor and the first conductive bump, and the first trace is further electrically connected to the third trace through the second conductive bump; and
the first trace and the third trace are ground traces, and the second trace is a power supply trace; or the first trace and the third trace are power supply traces, and the second trace is a ground trace.

2. The chip packaging structure according to claim 1, wherein the die further comprises a fourth trace, and the plurality of conductive bumps further comprise a third conductive bump;
the fourth trace is electrically connected to the second trace through the third conductive bump; and
both the second trace and the fourth trace are ground traces; or both the second trace and the fourth trace are power supply traces.

3. The chip packaging structure according to claim 1 or 2, wherein there are a plurality of first capacitors and a plurality of first conductive bumps, and the plurality of first capacitors are connected in parallel between the first trace and the second trace.

4. The chip packaging structure according to any one of claims 1 to 3, wherein the chip packaging structure further comprises a second capacitor; and
the second capacitor is disposed between the first conductive bump and the electronic component, and the first trace is electrically connected to the second trace through the first capacitor, the first conductive bump, and the second capacitor.

5. The chip packaging structure according to any one of claims 1 to 4, wherein the chip packaging structure further comprises a first seed layer disposed between the die and the plurality of conductive bumps, and a second seed layer disposed between the electronic component and the plurality of conductive bumps; and
the first capacitor is disposed between the first conductive bump and the first seed layer.

6. The chip packaging structure according to claim 4 or 5, wherein in a direction from the die to the electronic component, the first capacitor comprises a first electrode, a first dielectric layer, and a second electrode, and the first conductive bump is reused as the second electrode; and
in a direction from the electronic component to the die, the second capacitor comprises a third electrode, a second dielectric layer, and a fourth electrode, and the first conductive bump is further reused as the fourth electrode.

7. The chip packaging structure according to any one of claims 1 to 6, wherein the electronic component is a package substrate.

8. A flip chip packaging method, comprising:
sequentially forming a first capacitor and a plurality of first bumps on a die to obtain a first substrate, wherein the die comprises a first trace, the plurality of first bumps comprise a first sub-bump and a second sub-bump, and the first capacitor is located between the die and the first sub-bump;
forming a plurality of second bumps on an electronic component to obtain a second substrate, wherein the electronic component comprises a second trace and a third trace, and the plurality of second bumps comprise a third sub-bump and a fourth sub-bump; and
performing alignment and bonding on the first substrate and the second substrate, wherein the first sub-bump is aligned with the third sub-bump, the second sub-bump is aligned with the fourth sub-bump, the first trace is electrically connected to the second trace through the first capacitor, the first sub-bump, and the third sub-bump, and the first trace is further electrically connected to the third trace through the second sub-bump and the fourth sub-bump; and first trace and the third trace are ground traces, and the second trace is a power supply trace; or the first trace and the third trace are power supply traces, and the second trace is a ground trace.

9. The flip chip packaging method according to claim 8, wherein before forming the plurality of second bumps on the electronic component, the flip chip packaging method further comprises:
forming a second capacitor on the electronic component, wherein the second capacitor is located between the third sub-bump and the electronic component, and the first trace is electrically connected to the second trace through the first capacitor, the first sub-bump, the third sub-bump, and the second capacitor.

10. An electronic device, comprising a circuit board, a solder ball, and the chip packaging structure according to any one of claims 1 to 7, wherein the electronic component of the chip packaging structure is soldered to the circuit board through the solder ball.
